(19) Europäisches Patentamt
European Patent Office
Office européen des brevets

(11) Veröffentlichungsnummer: **0 140 188**
**B1**

# (12) EUROPÄISCHE PATENTSCHRIFT

(45) Veröffentlichungstag der Patentschrift: **07.01.88**

(51) Int. Cl.⁴: **H 03 K 19/094**

(21) Anmeldenummer: **84111726.0**

(22) Anmeldetag: **01.10.84**

## (54) CMOS-Inverter.

(30) Priorität: **28.10.83 DE 3339253**

(43) Veröffentlichungstag der Anmeldung: **08.05.85 Patentblatt 85/19**

(45) Bekanntmachung des Hinweises auf die Patenterteilung: **07.01.88 Patentblatt 88/1**

(84) Benannte Vertragsstaaten: **AT CH DE FR GB IT LI NL SE**

(56) Entgegenhaltungen:
**EP - A - 0 048 922**
**EP - A - 0 103 236**
**US - A - 3 678 293**
**US - A - 4 122 360**

**PATENTS ABSTRACTS OF JAPAN, Band 2, Nr. 143, 25. November 1978, Seite 8975 E78**
**IBM TECHNICAL DISCLOSURE BULLETIN, Band 16, Nr. 11, April 1974, Seiten 3577-3578, NEW YORK, (US). P.J. DAOUST et al.: "Small signal receiver circuit for complementary metal-oxide semiconductor circuits".**
**IBM TECHNICAL DISCLOSURE BULLETIN, Band 23, Nr.8, Januar 1981, Seite 3600, NEW YORK, (US). C.K.**

(73) Patentinhaber: **Siemens Aktiengesellschaft Berlin und München, Wittelsbacherplatz 2, D-8000 München 2 (DE)**

(72) Erfinder: **Schrenk, Hartmut, Dr.Phys., Fasanenweg 22, D-8013 Haar (DE)**

(56) Entgegenhaltungen: (Fortsetzung)
**ERDELYI: "Low-power inverter driver circuit".**
**PATENTS ABSTRACTS OF JAPAN, Band 7, Nr. 115 (E-176) (1260), 19. Mai 1983**
**PATENTS ABSTRACTS OF JAPAN, Band 6, Nr. 119 (E-116) (997), 3. Juli 1982.**
**PATENTS ABSTRACTS OF JAPAN, Band 3, Nr. 107 (E-136), 8. September 1979.**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



ACTORUM AG

## Beschreibung

Die Erfindung betrifft einen CMOS-Inverter, nach dem Oberbegriff des Patentanspruches 1.

Es gibt Anwendungsfälle für CMOS-Schaltungen, in welchen unterschiedliche Betriebsspannungen erforderlich sind. Beispielsweise müssen in elektrisch lösch- und programmierbaren Speichern ($E^2$PROMs) CMOS-Inverter, deren Betriebsspannung in einem sog. Hochvoltbereich um beispielsweise 20 V deutlich über einer sog. Niedervoltbetriebsspannung um beispielsweise 5 V liegt, von Niedervoltinvertern angesteuert werden. Der p-Kanal-MOS-FET eines Hochvoltinverters kann dabei aber wegen der zu niedrigen maximalen Ausgangsspannung des Niedervoltinverters nicht gesperrt werden, so dass ein statischer Querstrom fliesst.

Der Erfindung lag die Aufgabe zugrunde, einen CMOS-Inverter der o.g. Art anzugeben, welcher auch bei einem im Niedervoltbereich liegenden Eingangs-H-Pegel ein sicheres Sperren des p-Kanal-MOS-FET gewährleistet.

Diese Aufgabe wird bei einem CMOS-Inverter der eingangs genannten Art erfindungsgemäss durch die Merkmale des kennzeichnenden Teils des Patentanspruches 1 gelöst.

Weiterbildungen der Erfindung ergeben sich aus den Unteransprüchen.

Im folgenden wird die Erfindung anhand eines Ausführungsbeispiels weiter beschrieben.

Die Fig. zeigt einen CMOS-Hochvolt-Inverter, welcher aus einer Reihenschaltung eines selbstsperrenden n-Kanal-MOS-FET 1 und eines selbstsperrenden p-Kanal-MOS-FET 2 besteht. Die Steuereingänge dieser beiden MOS-FETs bilden gemeinsam den Invertereingang, welcher mit einer Steuerspannung $U_E$ beaufschlagt ist. Den Inverterausgang mit einem Ausgangssignal $U_A$ bildet der gemeinsame Drain-Anschluss der beiden MOS-FETs. In Reihe zum p-Kanal-MOS-FET 2 liegt ein selbstleitender n-Kanal-MOS-FET 3, dessen Steuereingang mit dem Inverterausgang verbunden ist. Der Drain-Anschluss des weiteren n-Kanal-MOS-FET 3 ist mit einer Betriebsspannung $U_{PP}$ beaufschlagt, die in einem Hochvoltbereich von z.B. 20 V liegt.

Die Eingangsspannung $U_E$ ist von einem vorgeschalteten Niedervolt-CMOS-Inverter 4 abgeleitet, der in dem wiedergegebenen Beispiel aus einer Reihenschaltung zweier selbstsperrender MOS-FETs besteht und mit einer Niedervolt-Betriebsspannung $U_{CC}$ um 5 V betrieben wird. Das Eingangssignal $U_E$ kann einen der beiden logischen Pegel L bzw. H einnehmen, wobei auch der H-Pegel in einem Niedervoltbereich liegt. Die Grösse der Eingangsspannung $U_E$, mit der ein Wert des Ausgangssignals $U_A$ von 0 Volt erreicht wird, ist bestimmt durch die Differenz des Betrages der Einsatzspannung $U_{Tn}$ des selbstleitenden n-Kanal-MOS-FETs 3 und des Betrages der Einsatzspannung $U_{Tp}$ des p-Kanal-MOS-FETs 2.

Für einen statisch stromarmen Zustand des oben beschriebenen Hochvolt-CMOS-Inverters mit einer Eingangsspannung $U_E$, die etwa der Niedervolt-Betriebsspannung $U_{CC}$ entspricht, ist im folgenden ein vorteilhaftes Dimensionierungsbeispiel gegeben. Die Niedervolt-Betriebsspannung liegt dabei bei 5 V, der Betrag der Einsatzspannung $U_{Tn}$ des selbstleitenden n-Kanal-MOS-FETs 3 liegt typisch bei 3 V, und der Betrag der Einsatzspannung $U_{Tp}$ des p-Kanal-MOS-FET 2 liegt typisch zwischen 0,5 V und 1 V. Um den Inverter mit niedrigem dynamischen Querstrom zu schalten, muss die Reihenschaltung des p-Kanal-MOS-FETs 2 und des selbstleitenden n-Kanal-MOS-FETs 3 schwachleitend gegenüber dem n-Kanal-MOS-FET 1 dimensioniert sein. Das ist der Fall, wenn bei dem selbstleitenden n-Kanal-MOS-FET 3 und/oder bei dem selbstsperrenden p-Kanal-MOS-FET 2 das Verhältnis aus Kanalweite und Kanallänge kleiner ist als bei dem selbstsperrenden n-Kanal-MOS-FET 1.

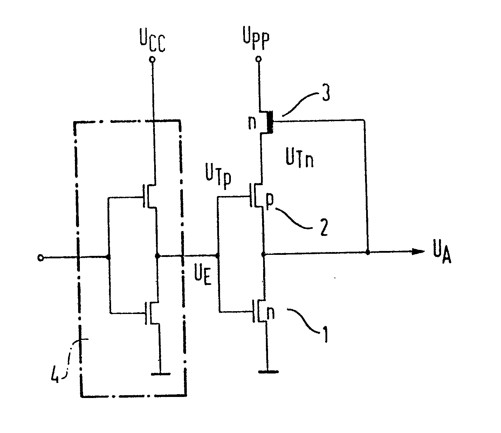

## Patentansprüche

1. CMOS-Inverter, bestehend aus einer Reihenschaltung eines selbstsperrenden p-Kanal-MOS-FET (2) und eines, mit seinem sourceseitigen Anschluss geerdeten, selbstsperrenden n-Kanal-MOS-FET (1), deren gemeinsamer Drain-Anschluss den Inverterausgang darstellt, dadurch gekennzeichnet, dass in Reihe zum p-Kanal-MOS-FET (2) ein selbstleitender n-Kanal-MOS-FET (3) geschaltet ist, dessen Steuereingang mit dem Inverterausgang verbunden ist und dessen freier Anschluss an einer Versorgungsspannung ($U_{pp}$) liegt, die grösser als die grösste Eingangsspannung ($U_E$) des Inverters ist.

2. CMOS-Inverter nach Anspruch 1, dadurch gekennzeichnet, dass er mit einer im Hochvoltbereich liegenden Betriebsspannung $U_{PP}$ beaufschlagt ist, und dass zum Ansteuern ein CMOS-Inverter mit einer kleineren Betriebsspannung ($U_{CC}$) vorgeschaltet ist.

3. CMOS-Inverter nach einem der Ansprüche 1 oder 2, dadurch gekennzeichnet, dass der selbstleitende n-Kanal-MOS-FET (3) schwächerleitend dimensioniert ist als der selbstsperrende n-Kanal-MOS-FET (1).

4. CMOS-Inverter nach einem der vorhergehenden Ansprüche, dadurch gekennzeichnet, dass der selbstsperrende p-Kanal-MOS-FET (2) schwächer leitend dimensioniert ist als der selbstsperrende n-Kanal-MOS-FET (1).

## Revendications

1. Inverseur CMOS, constitué par un circuit série comportant un transistor à effet de champ MOS à canal p et du type autobloquant (2) et un transistor à effet de champ MOS à canal n et du type autobloquant (1), la borne de drain commune à ces deux transistors représentant la sortie de l'inverseur, caractérisé par le fait qu'en série avec le transistor à effet de champ MOS à canal p (2) est monté un transistor à effet de champ MOS à canal n et du type à autoconduction (3), dont l'entrée de commande est reliée à la sortie de l'inverseur et dont la borne libre est reliée à une tension d'alimentation ($U_{pp}$) qui est supérieure à la tension d'entrée la plus grande ($U_E$) de l'inverseur.

2. Inverseur CMOS selon la revendication 1, caractérisé par le fait qu'il est chargé avec une tension de fonctionnement ($U_{pp}$) qui se situe dans la zone haute-tension, et que pour l'attaque, on prévoit en aval, un inverseur CMOS avec une tension de fonctionnement ($U_{CC}$) plus faible.

3. Inverseur CMOS selon l'une des revendications 1 à 2, caractérisé par le fait que le transistor à effet de champ MOS à canal n et du type à autoconduction (3) est dimensionné de façon à avoir une conduction plus faible que le transistor à effet de champs MOS à canal n et à autoblocage (1).

4. Inverseur CMOS selon l'une des revendications précédentes, caractérisé par le fait que le transistor à effet de champ MOS à canal p et à autoblocage (2) est dimensionné de manière présenter une conduction plus faible que le transistor à effet de champ MOS à canal n et à autoblocage (1).

**Claims**

1. A CMOS inverter consisting of a series arrangement of a self-blocking p-channel MOS-FET (2) and a self-blocking n-channel MOS-FET (1) earthed at its source-side terminal, its common drain terminal serving as the inverter output, characterised in that the p-channel MOS-FET (2) is connected in series with a self-conducting n-channel MOS-FET (3) whose control input is connected to the inverter output and whose free terminal is connected to a supply voltage ($U_{pp}$) greater than the maximum input voltage ($U_E$) of the inverter.

2. A CMOS inverter as claimed in Claim 1, characterised in that it is supplied with an operating voltage ($U_{pp}$) in the high voltage range, and that for driving purposes a CMOS inverter with a low operating voltage ($U_{CC}$) is connected in series.

3. A CMOS inverter as claimed in one of Claims 1 or 2, characterised in that the self-conducting n-channel MOS-FET (3) is dimensioned to be more weakly conductive than the self-blocking n-channel MOS-FET (1).

4. A CMOS inverter as claimed in any preceding Claim, characterised in that the self-blocking p-channel MOS-FET (2) is dimensioned to be more weakly conductive than the self-blocking n-channel MOS-FET (1).

UCC
UPP
3
n
UTn
UTp
p
2
UA
UE
n
1
4